(19) **Europäisches Patentamt European Patent Office Office européen des brevets**

(11) **EP 4 756 464 A1**

(12) **EUROPEAN PATENT APPLICATION**

(43) Date of publication:
**10.06.2026 Bulletin 2026/24**

(21) Application number: **25220481.3**

(22) Date of filing: **03.12.2025**

(51) International Patent Classification (IPC):
**G01R 31/64** (2020.01)  **G01R 1/44** (2006.01)

(52) Cooperative Patent Classification (CPC):
**G01R 31/64; G01R 1/44**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **05.12.2024 US 202418970102**

(71) Applicant: **Aptiv Technologies AG
8200 Schaffhausen (CH)**

(72) Inventors:
- **SADABADI, Kaveh Khodadadi
  8200 Schaffhausen (CH)**
- **WANG, Xu
  8200 Schaffhausen (CH)**

(74) Representative: **Bardehle Pagenberg
Partnerschaft mbB
Patentanwälte Rechtsanwälte
Prinzregentenplatz 7
81675 München (DE)**

(54) **ESR AND CAPACITANCE LEARNING FOR ULTRA-CAPACITOR CONTROL MODULE**

(57) A method of determining status of health (SOH) of an ultra-capacitor cell stack having a plurality of ultra-capacitor cells. The method includes measuring a parameter of each of the plurality of ultra-capacitor cells and measuring a temperature associated with each of the ultra-capacitor cells. The parameter measured with re- spect to each of the plurality of ultra-capacitor cells is converted to a nominal parameter based on the mea- sured temperature. The SOH of the UCM cell stack is calculated based on the nominal parameters associated with each of the plurality of ultra-capacitor cells.

**FIG. 1**

## Description

### TECHNICAL FIELD

The subject matter disclosed herein relates to ultra-capacitor cells and in particular to estimating parameters associated with the ultra-capacitor cells.

### BACKGROUND

Ultra-capacitor modules are oftentimes used in vehicle applications. Ultra-capacitors store energy rapidly and can provide quick bursts of power utilized for acceleration and regenerative braking. Ultra-capacitors may also be utilized to selectively add/store energy to a vehicle power bus.

A number of parameters can be monitored to assess the health and operation of an ultra-capacitor module, including State of Health (SOH), State of Charge (SOC), and State of Function (SOF), along with ultra-capacitor specific parameters equivalent series resistance (ESR) and capacitance. The measurement of the ultra-capacitor specific parameters ESR and capacitance requires providing a very specific current profile and making voltage measurements at specific points along the current profile. Measuring the capacitance typically requires applying a relatively low amp current profile for several minutes.

It would be beneficial to reduce the amount of time required to measure ESR and capacitance parameter associated with ultra-capacitors.

### SUMMARY

In some aspects, the techniques described herein relate to a method of determining status of health (soh) of an ultra-capacitor cell stack having a plurality of ultra-capacitor cells, the method including: measuring a parameter of each of the plurality of ultra-capacitor cells; measuring a temperature associated with each of the ultra-capacitor cells; converting the parameter measured with respect to each of the plurality of ultra-capacitor cells to a nominal parameter based on the measured temperature; calculating the soh of the cell stack based on the nominal parameters associated with each of the plurality of ultra-capacitor cells.

In some aspects, the techniques described herein relate to a method of measuring capacitance of ultra-capacitor cells, the method including: applying a current waveform to the ultra-capacitor cell; measuring voltages at a plurality of time steps associated with the current waveform; calculating a differential capacitance based on the measured voltages; and calculating an actual capacitance based on a known relationship between the differential capacitance and the actual capacitance.

### BRIEF DESCRIPTION OF THE DRAWINGS

FIG. 1 is a block diagram of a vehicular electrical system utilizing an ultracapacitor control module (UCM) according to some embodiments.

FIG. 2 is a schematic diagram of system components of an ultracapacitor control module according to some embodiments.

FIG. 3 is a flowchart illustrating the measurement of temperature independent (nominal) ESR/capacitance parameters and subsequent use of these parameters to calculate temperature dependent (actual) ESR/capacitance parameters according to some embodiments.

FIG. 4 is a flowchart illustrating steps utilized to calculate nominal ESR according to some embodiments.

FIG. 5 is a diagram of a current profile applied to the ultra-capacitor cell and timing of corresponding voltage measurements according to some embodiments.

FIG. 6 is a 3D plot that illustrates the calculation of nominal ESR parameter based on measured ESR and measured temperature according to some embodiments.

FIG. 7 is a 3D plot that illustrates the calculation of an actual ESR parameter based on the previously calculated nominal ESR value and measured (current) temperature value according to some embodiments.

FIG. 8 is a flowchart illustrating steps utilized to calculate nominal capacitance parameter according to some embodiments.

FIG. 9 is a graph illustrating the relationship between differential capacitance and actual capacitance according to some embodiments.

FIG. 10 is a 3D plot that illustrates the calculation of nominal capacitance parameter based on measured capacitance and measured temperature according to some embodiments.

**FIG. 11** is a 3D plot that illustrates the calculation of an actual capacitance parameter based on the previously calculated nominal capacitance value and measured (current) temperature value according to some embodiments.

## DETAILED DESCRIPTION

Equivalent series resistance (ESR) and capacitance are parameters associated with ultra-capacitor cells and utilized in the operation of ultra-capacitors cells. In addition, these parameters have been found to vary with age/health of the ultra-capacitor cell and can therefore be utilized to assess the age/health of the ultra-capacitor cell. However, because these parameters vary with temperature it can be difficult to monitor these parameters over time and correlate changes in either to degradation in age/health of the ultra-capacitor cell rather than variations in temperature at the time of measurement. The claimed invention provides a method of learning the ESR and/or capacitance of an ultra-capacitor cell that is not dependent on the temperature of the ultra-capacitor cell at the time of the learning. In particular, the claimed invention measures the ESR/capacitance and the temperature. The measured ESR/capacitance measured at a given temperature is converted to a nominal ESR/capacitance value associated with a selected nominal temperature (i.e., temperature independent ESR/capacitance values). The nominal ESR/capacitance parameter can then be utilized to assess the state of health (SOH) of the ultra-capacitor cell.

In addition, as the temperature of the ultra-capacitor cell varies with time, the nominal parameters can be utilized in combination with up-to-date temperature measurements to generate up-to-date ESR and/or capacitance values without requiring a re-test or re-learning of these parameters.

In addition, a method of measuring the capacitance of the ultra-capacitor cell on a much shorter timescale than a typical capacitance measurement is provided by utilizing differential capacitance measurements. In some embodiments, in contrast with typical capacitance measurements which require the application of a relatively low ampere current (e.g., 10mA/F) over a long duration of time (e.g., 10 minutes), measuring differential capacitance allows for use of a current having an order of magnitude higher ampere current than the rated current of the capacitor (e.g., 100 mA/F) over relatively short period of time (e.g., under a minute). The differential capacitance is related to the actual capacitance and can be mapped (via look-up table or similar) to the actual capacitance value. In some embodiments, the last voltage measured as part of the differential capacitance is fixed with respect to the first voltage measured (i.e., fixed amount of voltage rise).

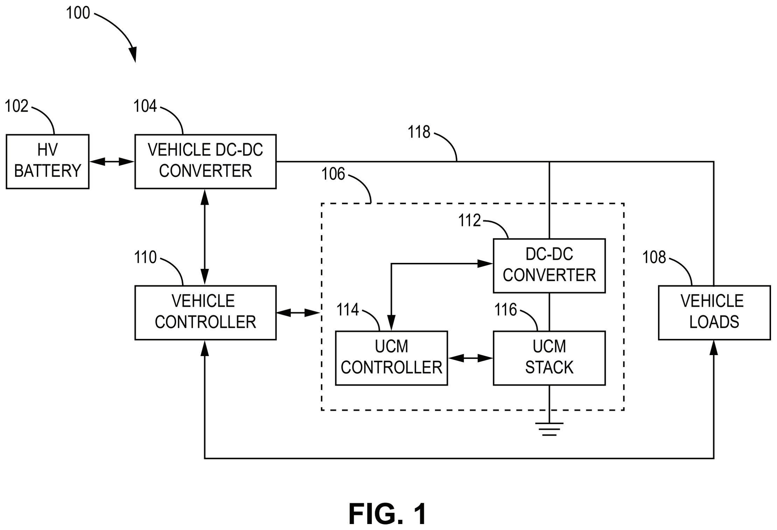

**FIG. 1** is a block diagram of a vehicular electrical system 100 utilizing an ultracapacitor control module (UCM) 106 according to some embodiments. Vehicular electrical system 100 may include a high voltage (HV) battery 102, a vehicle DC-to-DC converter 104, and one or more vehicle loads 108 electrically connected via a voltage bus 118. In some embodiments, the UCM 106 includes a DC-to-DC converter 112, a UCM controller (e.g., digital signal processor (DSP)) 114, and an ultra-capacitor cell stack 116 having at least one ultra-capacitor cell. As shown in FIG. 1, the DC-to-DC converter 112 is connected in series between the ultra-capacitor cell stack 116 and the voltage bus 118. As described in more detail below, in some embodiments, DC-to-DC converter 112 is able to control the current supplied to (or from) the ultra-capacitor cell stack 116. As a result, the UCM 106 is able to autonomously generate the current waveforms required to measure one or more parameters of the ultra-capacitor cell stack 116, including equivalent series resistance (ESR) and capacitance. In some embodiments, HV battery 102 and vehicle DC-DC converter 104 make available on voltage bus 118 a sufficient amount of power for UCM 106 - in particular, DC-DC converter 112 - to generate the desired current waveforms for measuring the one or more parameters associated with the ultra-capacitor cell stack 116. In this embodiment, vehicle DC-DC converter 104 is not utilized to generate the desired current waveforms. In some embodiments, vehicle controller 110 may communicate bi-directionally with the UCM 106, including providing inputs utilized to initiate a parameter test and to receive the parameters measured or estimated by the UCM 106. In this way, UCM 106 is capable of autonomously generating the current waveforms required to measure the one or more parameters of the ultra-capacitor cell stack 116. It should be noted, that in other embodiments rather than UCM 106 autonomously measuring the one or more parameters of the ultra-capacitor cell stack 116, vehicle controller 110 may operate in conjunction with vehicle DC-to-DC converter 104 to generate the current waveforms required to measure the one or more parameters of the ultra-capacitor stack 116. In this embodiment, the DC-DC converter 112 included as part of the UCM 106 would not be required as vehicle DC-to-DC converter 104 would be responsible for generating the desired waveforms.

In the embodiment shown in **FIG. 1,** HV battery 102 supplies/draws power to/from the voltage bus 118 via vehicle DC-to-DC converter 104. Likewise, UCM 106 is configured to supply/draw power to/from the voltage bus 118. Vehicle loads 108 draw power from the voltage bus 118. In some embodiments, vehicle controller 110 communicates with vehicle DC-to-DC converter 104, UCM 106, and with vehicle loads 108. In some embodiments, communication is bi-directional and may include providing operational instructions to each component and/or receiving feedback (e.g., monitored parameters) from each component as part of a UCM test (e.g., measuring of ESR and/or capacitance). For example, as discussed in more detail below, before initiating a UCM test, the vehicle controller 110 may receive feedback regarding the status of the vehicle (in motion, stopped, etc.) as well as status from vehicle loads 108 regarding the current load status of the vehicle. In some embodiments, vehicle controller 110 may provide instructions to vehicle loads 108 to turn ON or OFF. For example, in some embodiments vehicle controller 110 may provide instructions to vehicle loads 108 instructing at least one of the vehicle loads to be turned ON to provide a discharge path for UCM 106 during one or more stages of the UCM test. In other embodiments, vehicle controller 110 may provide instructions to vehicle loads 108 to maintain one or more of the loads in the OFF state during one or more stages of the UCM test to ensure sufficient energy is available to UCM 106 during the test. Vehicle controller 110 may also provide instructions to vehicle DC-DC converter 104 instructing the DC-DC converter 104 to make sufficient power available to voltage bus 118 for conducting the UCM test. Vehicle controller 110 may also provide instructions to UCM 106 regarding initiation of the UCM test and may receive feedback regarding the measured results of the UCM test.

Although not shown in **FIG. 1,** in other embodiments, the vehicular electrical system 100 may include a number of other components, including a plurality of additional energy sources, including various types of batteries (e.g., AGM/Li ion), generator/alternators, etc., as well as various other vehicular loads. In some embodiments, the vehicle electrical system 100 may include a power distribution controller/switch utilized to control the distribution of power between the plurality of energy sources and the plurality of various loads. As described in more detail below, UCM 106 tests involve providing particular current waveforms to the UCM cell stack 116 and monitoring the response. One of the advantages of employing series connected DC-DC converter 112 included as part of the UCM 106 to test the parameters of the ultra-capacitor cell stack 116 is that DC-DC converter 112 is utilized to generate the particular current waveforms - rather than vehicle DC-DC converter 104. In some embodiments, relying on DC-DC converter 112 to generate the desired current waveforms reduces the error associated with the desired current waveform because the tolerances of the vehicle DC-DC converter 104 do not affect the current waveform generated by DC-DC converter 112. In some embodiments, the tolerances associated with DC-DC converter 112 may be lower than tolerances associated with vehicle DC-DC converter, further reducing error associated with the desired current waveform generated. However, in other embodiments the vehicle controller 110 could utilize the vehicle DC-DC converter 104 to provide the particular current waveforms to the UCM cell stack 116 and measure the response. In this embodiment, vehicle controller 110 may be configured to measure the responses to the current waveform provided and would not require UCM controller 114. That is, in this embodiment the UCM 106 is a passive UCM cell stack 116 and does not include components like UCM controller 114 and DC-DC converter 112 to actively control operation of the UCM 106.

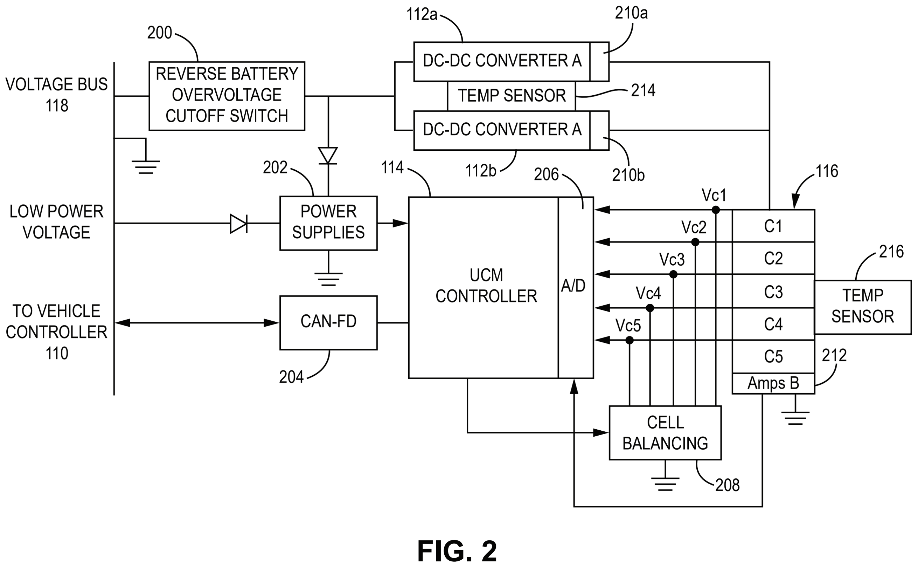

**FIG. 2** is a schematic diagram of system components of an ultracapacitor control module (UCM) 106 according to some embodiments. In some embodiments, the UCM 106 includes first and second DC-to-DC converters 112a and 112b, UCM controller 114 (e.g., digital signal processor (DSP)) 114, and ultra-capacitor cell stack 116, which in this embodiment includes individual ultra-capacitor cells C1-C5. In addition, the UCM 106 includes a reverse battery overvoltage cutoff switch 200, power supply 202, communication input 204 (e.g., controller area network (CAN) bus flexible data (FD) input), analog-to-digital converter (ADC) 206, cell balancing circuit 208, current measurement sensors 210a, 210b, and 212, and temperature sensors 214 and 216. In some embodiments, temperature sensor 214 is utilized to monitor the temperature of DC-DC converters 112a, 112b, with temperature feedback being provided to UCM controller 114. Likewise, in some embodiments temperature sensor 216 is utilized to monitor the temperature of the ultra-capacitor cell stack 116, with temperature feedback being provided to UCM controller 114. In some embodiments, temperature sensor 216 includes a plurality of temperature sensors, each temperature sensor configured to monitor one or more ultra-capacitor cells C1-C5. For example, each of the plurality of ultra-capacitor cells C1-C5 may have a temperature sensor configured to measure the temperature of the corresponding cell. In this way, measuring a temperature associated with the ultra-capacitor cells C1-C5 may include measuring a single temperature value associated with each of the ultra-capacitor cells or measuring a plurality of individual temperature values, each temperature value associated with one or more of the plurality of ultra-capacitor cells C1-C5.

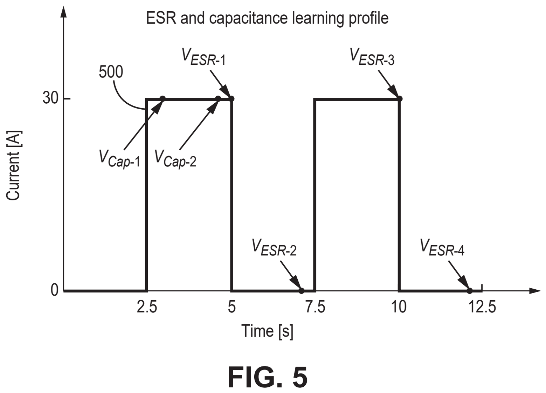

As shown in **FIG. 2,** both the first and second DC-to-DC converters 112a, 112b are connected in series between the voltage bus 118 and the ultra-capacitor cell stack 116. During parameter testing, the DC-to-DC converters 112a, 112b sources current having a desired current profile to the plurality of ultra-capacitor cells in the ultra-capacitor cell stack 116. In some embodiments, each DC-to-DC converter 112a, 112b includes a current measurement sensor 210a, 210b, respectively, utilized to measure the current provided to/from each DC-to-DC converter 112a, 112b to the plurality of ultra-capacitor cells C1-C5. In some embodiments, currents measured by current measurement sensors 210a, 210b are utilized by UCM controller 114 to balance the current provided by DC-to-DC converter 112a, 112b. In embodiments in which only a single DC-to-DC converter 112 is utilized, no current balancing is required. In some embodiments, UCM controller 114 monitors the current supplied to the plurality of ultra-capacitor cells C1-C5. In the embodiment shown in **FIG. 2,** current measurement sensor 212 is utilized to monitor the current provided by DC-to-DC converters 112a, 112b to the plurality of ultra-capacitor cells C1-C5. In some embodiments, the UCM controller 114 utilizes the current monitored by the current measurement sensor 212 in feedback to control the current profile sourced by the DC-DC converters 112a, 112b. In addition, the current monitored by the current measurement sensor 212 may be utilized in combination with other monitored parameters to calculate parameters such as ESR and capacitance. For example, **FIG. 5** illustrates the desired current profile utilized to measure the ESR and capacitance of each of the plurality of ultra-capacitor cells C1-C5 according to some embodiments. The measurement tolerances associated with current sensors 210a, 210b, and 212 dictate the accuracy of the current profiles provided to the plurality of ultra-capacitor cells C1-C5. In some embodiments, only the tolerances of current sensors 210a, 210b, and 212 need to be taken into account for determining the accuracy of the measured parameters. In some embodiments, the current sensors 210a, 210b, and 212 utilized to monitor the currents sourced by the DC-to-DC converters 112a, 112b are calibrated during production of each UCM 106 to ensure accuracy.

In some embodiments, the UCM controller 114 is configured to monitor voltage at each of the plurality of ultra-capacitor cells C1-C5 via a plurality of voltage sensors ($V_{C1}$, $V_{C2}$, $V_{C3}$, $V_{C4}$, $V_{C5}$). ADC 206 converts the analog signals to a digital signal provided to UCM controller 114. In response to the current profile generated by the first and/or second DC-to-DC converters 112a, 112b, the plurality of voltage measurements are taken at various points within the applied current profile and utilized to calculate parameters such as ESR and capacitance. In some embodiments, UCM controller 114 converts the measured ESR and capacitance to nominal values that are independent of temperature based on the temperature of the UCM cell stack 116 at the time of measurement. For example, in some embodiments ESR and capacitance measurements are converted to nominal values associated with a selected temperature (e.g., 20°C). In this way, subsequent ESR and capacitance measurements - also converted to nominal values associated with the same selected temperature - can be compared to one another and utilized to assess the state of health of the individual ultra-capacitor cells C1-C5 and/or of the ultra-capacitor cell stack 116.

In some embodiments, UCM controller 114 may communicate with vehicle controller 110 (shown in FIG. 1) via CAN-FD bus 204. Communication may include instructions provided by the vehicle controller 110 to initiate parameter testing, communications regarding whether conditions are optimal for parameter testing, etc. In addition, UCM controller 114 may provide feedback to the vehicle controller 110 regarding monitored parameters (e.g., ESR, capacitance, nominal ESR, nominal capacitance, SOH, and others). In some embodiments, nominal ESR and/or nominal capacitance values may be communicated to the vehicle controller 110 and the vehicle controller 110 may calculate SOH values. In other embodiments, SOH is calculated by the UCM controller 114 and communicated to the vehicle controller 110. In some embodiments, vehicle controller 110 utilizes the monitored parameters to determine the health of the UCM 106 and may generate alerts if the health of the UCM 106 falls below a threshold level.

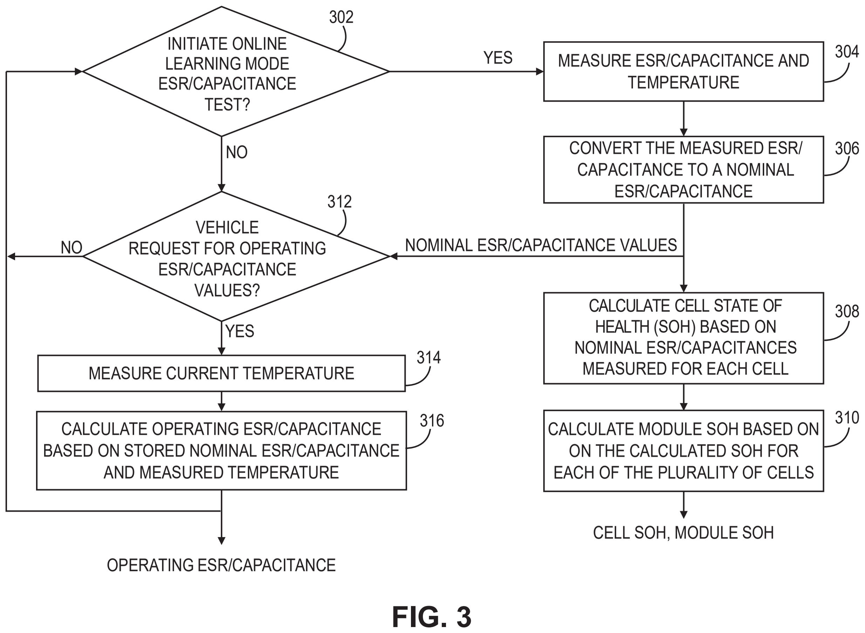

**FIG. 3** is a flowchart illustrating the measurement and conversion of measured parameters to nominal (i.e., temperature independent) parameters and subsequent use of these parameters to calculate temperature dependent (actual) parameters according to some embodiments.

At step 302, an online learning mode is initiated to measure parameters associated with the one or more of the ultra-capacitor cells C1-C5 associated with UCM cell stack 116. In some embodiments, the online learning mode is initiated by the vehicle controller 110 and communicated to the UCM controller 114 to initiate the online learning mode. In some embodiments, the vehicle controller 110 determines whether conditions are appropriate for initiating the test. For example, in some embodiments this may include vehicle controller 110 ensuring that the vehicle is not moving, that the vehicle is not using energy provided on voltage bus 118, that the power source providing power to the UCM module 106 (e.g., HV battery 102) is turned ON and that enough current is available to support the current profile required to measure ESR and capacitance (e.g., the current profile shown in FIG. 5). If these conditions are met, then vehicle controller 110 will communicate with UCM controller 114 to initiate the online learning mode.

If at step 302 it is determined that the online learning mode should be initiated, then at step 304 the current profile (e.g., shown in **FIG. 5**) required to measure one or both of equivalent series resistance (ESR) and capacitance are generated, voltages associated with one or more of the ultra-capacitor cells C1-C5 are measured at given intervals, and one or both of the parameters ESR and capacitance are measured. In some embodiments, ESR/capacitance parameters are measured with respect to each ultra-capacitor cell C1-C5 (i.e., five separate ESR/capacitance measurements). In other embodiments, ESR/capacitance parameter is measured with respect to the entire UCM cell stack 116 (i.e., a single ESR/capacitance measurement). In other embodiments, ESR/capacitance measurements are made with respect to both individual ultra-capacitor cells and the entire UCM cell stack 116.

In addition to measured parameters, the temperature of the ultra-capacitor cells C1-C5 and/or of the entire UCM cell stack 116 is also measured, referred to as the online learning mode temperature ($T_{OLM}$). For example, in some embodiments temperature sensor 216 measures a temperature associated with the ultra-capacitor stack 116. In other embodiments, a plurality of temperature sensors are utilized to measure temperatures associated with each of the plurality of cells C1-C5 in the ultra-capacitor stack 116.

At step 306 the measured parameters (one or both of ESR and capacitance) are converted to nominal parameter values based on the online learning mode temperature $T_{OLM}$. The conversion to a nominal parameter removes the temperature dependence from the measured parameters. In some embodiments, the nominal parameter is associated with a nominal temperature (e.g., 20°C) and may be selected to be approximately in the middle of the operating range of the ultra-capacitor cells C1-C5. In other embodiments, other nominal temperatures may be selected.

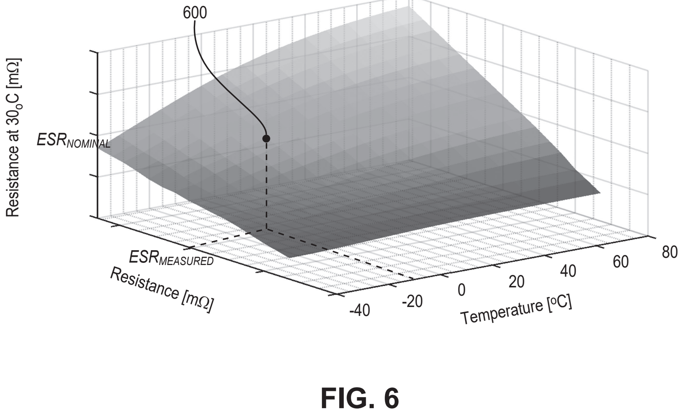

The conversion of the measured parameters to nominal parameters relies on the known relationship between the parameters and temperature. For example, **FIG. 6** is a graph that illustrates the relationship between measured ESR, temperature, and nominal ESR at a selected temperature. If the online learning mode temperature $T_{OLM}$ is -10°C (as shown in **FIG. 6**) and the parameter measured is assigned a value (e.g., $ESR_{measured}$ (mΩ)), then the known relationship between the measured parameter and the online learning mode temperature is utilized to convert the measured parameter (e.g., $ESR_{measured}$) to a nominal parameter (e.g., $ESR_{nominal}$) - in this case associated with a nominal temperature of 30°C. The nominal value (e.g., $ESR_{measured}$) represents the expected parameter value if the online learning mode had been initiated at nominal temperature of 30°C.

In some embodiments, previous data is utilized to guide the conversion of measured parameters to nominal parameters. For example, the conversion may rely on look-up tables, equations reflecting the relationship between the parameter and temperature, or graphs such as those shown in **FIG. 6** that relate the parameter and temperature.

At step 308, the nominal parameters calculated at step 306 is utilized to calculate the state of health (SOH) of the one or more ultra-capacitor cells C1-C5 and/or of the UCM cell stack 116 as a whole. In some embodiments, a cell SOH value is determined for each of the plurality of ultra-capacitor cells C1-C5 and the plurality of cell SOH values are subsequently utilized to estimate the ultra-capacitor cell stack SOH. In some embodiments, the cell SOH is calculated based on a comparison of the measured parameter to a threshold value. In some embodiments, the cell SOH is calculated based on a comparison of the measured parameter to a beginning of life (BOL) value and to an end of life (EOL) value. For example, using nominal ESR values as an example, the cell SOH is calculated as:

$$SOH_{ESR,ii} = \frac{ESR_{nom,EOL} - \widehat{ESR}^f_{nom,k\,ii}}{ESR_{nom,EOL} - ESR_{nom,BOL}} \tag{1}$$

where $ESR_{nom,EOL}$ is the nominal ESR EOL value, $\widehat{ESR}^f_{nom,k\,ii}$ is the nominal ESR value measured in the $k^{the}$ online learning mode pulse profile for the $ii$ cell, $ESR_{nom,BOL}$ is the nominal ESR BOL value. In some embodiments, the nominal ESR EOL value $ESR_{nom,EOL}$ is assigned a value related to the nominal ESR BOL value $ESR_{nom,BOL}$, for example as follows:

$$ESR_{nom,EOL} = 2 * ESR_{nom,BOL} \tag{2}$$

Likewise, cell SOH may be calculated based on nominal capacitance as follows:

$$SOH_{C,ii} = \frac{\widehat{Cap}^f_{nom,k,ii} - C_{nom,EOL}}{C_{rated} - C_{nom,EOL}} ; \forall ii = 1{:}N_{cell} \tag{3}$$

where $C_{rated}$ is the rated capacitance of the cell and the overall cell number is $N_{cell}$. Likewise, the nominal capacitance EOL value $C_{nom,EOL}$ is assigned a value related to the rated capacitance $C_{rated}$ of the cell, for example as follows:

$$C_{nom,EOL} = 0.8 \cdot C_{rated} \tag{4}$$

In this way, ESR-based SOH values are generated for each of the plurality of cells C1-C5 utilizing nominal ESR values and capacitance-based SOH values are generated for each of the plurality of cells C1-C5 utilizing nominal capacitance values.

At step 310, the state of health (SOH) for the entire ultra-capacitor stack 116 is calculated, referred to herein as the cell stack SOH. In some embodiments, a cell stack ESR-based SOH is calculated based on the plurality of cell ESR-based SOH values and a cell stack capacitance-based SOH is calculated based on the plurality of cell capacitance-based SOH values. For example, the cell stack ESR-based SOH is calculated as follows:

$$SOH_{ESR} = \min_{ii} (SOH_{ESR,ii}) ; \forall ii = 1{:}N_{cell} \tag{5}$$

Essentially, the minimum cell ESR-based SOH value is selected as representative of the cell stack ESR-based SOH. In other embodiments, instead of a minimum value selected from the plurality of cell ESR-based SOH values, an average of the plurality of cell ESR-based SOH values may be utilized. Likewise, the cell stack capacitance-based SOH is calculated as follows:

$$SOH_C = \min_{ii} SOH_{C,ii} ; \forall ii = 1{:}N_{cell} \tag{6}$$

The minimum cell capacitance-based SOH value is selected as representative of the cell stack capacitance-based SOH. Once again, instead of a minimum value selected from the plurality of cell capacitance-based SOH values, an average of the plurality of cell capacitance-based SOH values may be utilized. The cell stack SOH is calculated as a combination of the cell stack ESR-based SOH and the cell stack capacitance-based SOH. For example, in some embodiments the cell stack SOH is calculated as the minimum of the cell stack ESR-based SOH and the cell stack capacitance-based SOH, as provided below:

$$SOH = min(SOH_C, SOH_{ESR}) \tag{7}$$

In some embodiments, the cell stack SOH is provided as an output. In other embodiments, both the cell stack SOH and the plurality of cell SOH values are provided as an output. The cell SOH values and cell stack SOH values may be provided as an output to vehicle controller 110. In other embodiments these values are stored by UCM controller 114.

In this way, steps 304, 306, 308 and 310 describe the online learning method utilized to measure ESR/capacitance values, convert the measured values to nominal ESR/capacitance values, and utilize the nominal ESR/capacitance values to assess the state of health (SOH) of the plurality of cells and the larger module. In addition, the nominal ESR/capacitance values calculated at step 306 may be subsequently utilized during operation of the vehicle to assess the operating ESR/capacitance value. In particular, because ESR and capacitance values may vary with temperature, the ESR/capacitance values measured at step 304 (even if measured at the start of a trip or on the same day) may not reflect the operating ESR/capacitance values due to changes in temperature. As described with respect to steps 314 and 316, the nominal ESR/capacitance values can be utilized to calculate the operating ESR/capacitance values during vehicle operation.

In some embodiments, the operating ESR/capacitance values are calculated in response to a request from the vehicle controller 110. At step 312, a determination is made whether such a request has been received. If no request has been received, then no additional steps are taken. In response to a request for operating ESR/capacitance values at step 312, then at step 314 the temperature of the ultra-capacitor stack 116 is measured. In some embodiments, temperature sensor 216 shown in **FIG. 2** is utilized to measure the current temperature of the ultra-capacitor stack 116.

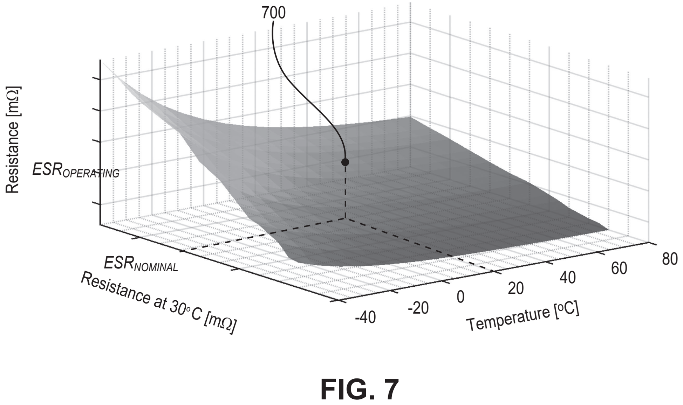

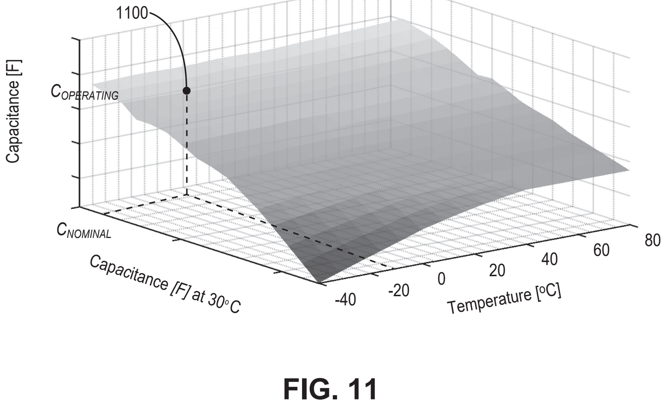

At step 316, an operating parameter (i.e., current ESR/capacitance value) is calculated based on the nominal ESR/capacitance value (measured at step 306) and the operating or current temperature measured at step 314. As discussed above, the nominal parameter represents the parameter measured during the online learning mode standardized to a nominal temperature. At step 316, given the operating temperature of the ultra-capacitor cells C1-C5, the operating parameter is calculated from the nominal parameter. In some embodiments, the relationship between nominal parameter, operating temperature, and operating parameter is known based on previously collected data. For example, previously collected data may include cell accelerated life cycle test data. In some embodiments the relationship between operating parameter and operating temperature is stored in look-up tables, equations reflecting the relationship between operating parameter and operating temperature, or graphs based on the collected data, for example, from cell accelerated life cycle test (as shown in **FIG. 7,** for example). With reference to **FIG. 7,** if the nominal ESR value is $ESR_{nominal}$ mΩ (and corresponds with a temperature of 30°C), and the operating temperature is 20°C, then the graph in **FIG. 7** can be utilized to determine the current or operating ESR value (e.g., $\sim ESR_{operating}$ mΩ). **FIG. 11** illustrates this concept for determining the current operating capacitance value $C_{operating}$ based on the nominal capacitance $C_{nominal}$ and operating temperature. In this way, an operating parameter is provided that accounts for the current operating temperature of the ultra-capacitor cells C1-C5 without requiring repeating the initiation of the current profile and measurement of voltages shown at step 304. The operating parameter (e.g., ESR/capacitance) is provided as an output to the vehicle controller.

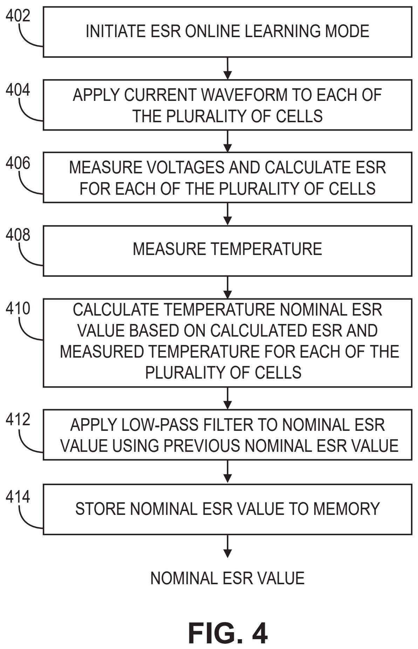

**FIG. 4** is a flowchart illustrating steps utilized to calculate nominal ESR parameter according to some embodiments. At step 402, the ESR online learning mode is initiated.

At step 404, a current waveform is applied to the UCM cell stack 116, which includes the plurality of ultra-capacitor cells C1-C5. An example of the current waveform is shown in **FIG. 5,** in which a plurality of pulses of a given magnitude are applied to the UCM cell stack 116. In the example shown in **FIG. 5,** the amplitude of the current pulse is labeled *I_pulse* and is approximately an order of magnitude greater than the rated current capacitance of the ultra-capacitor stack 116 (e.g., 30 amps).

At step 406, voltages are measured at selected points along the current waveform. For example, for ESR measurement, four voltages are measured, labeled $V_{ESR-1}$, $V_{ESR-2}$, $V_{ESR-3}$, $V_{ESR-4}$. In some embodiments, $V_{ESR-1}$ and $V_{ESR-3}$ are measured just before the first and second pulses end, respectively, $V_{ESR-2}$ and $V_{ESR-4}$ are measured a fixed time *Time_rest_ESR* after the first and second pulses are removed, respectively. Based on these measurements, the ESR for a given ultra-capacitor cell C1-C5 is calculated based on the following equation:

$$ESR = (V_{ESR\_1} - V_{ESR\_2})/I\_Pulse \tag{8}$$

or

$$ESR=(V_{ESR\_3} - V_{ESR\_4})/I\_Pulse \qquad (9)$$

In some embodiments, the ESR value of a given cell is assigned the average of the ESR values calculated in Eq. (8) and (9). For the purposes of clarity, the ESR measured at step 406 is referred to as the measured ESR value.

At step 408, the temperature of the UCM cell stack 116 is measured by the temperature sensor 216 (shown in **FIG. 1**). As discussed above, in some embodiments a plurality of temperature sensors may be utilized to measure temperature associated with each of the plurality of ultra-capacitor cells C1-C5.

At step 410, a nominal ESR value is calculated based on the ESR measured at step 406 and the temperature measured at step 408. The nominal ESR value is calculated to remove the temperature dependence of the ESR parameter. The measured ESR - measured at a known temperature - is converted to a nominal ESR value that is associated with a set temperature (e.g., 30°C). Subsequent measured ESR values - perhaps measured at a different temperature - are likewise converted to a nominal ESR value associated with the same set temperature allowing the nominal ESR value to be utilized to determine SOH of each of the plurality of cells.

At step 412, a low pass filter is applied to the nominal ESR value calculated at step 410 using a previously measured nominal ESR value. For example, in some embodiments, the previously stored nominal ESR value ( $\widehat{ESR}^f_{nom,k-1}$ ) is compared with the current ESR value ( $\widehat{ESR}^f_{nom,k}$ ) as follows:

$$\widehat{ESR}^f_{nom,\,k} = (1 - \lambda_{esr}) \cdot \widehat{ESR}^f_{nom,\,k-1} + \lambda_{esr} \cdot \widehat{ESR}_{nom,k} \qquad (10)$$

where the value of $\lambda_{esr}$ is determined based on the following:

$$if \begin{cases} abs\left(\widehat{ESR}_{nom,k} - \widehat{ESR}^f_{nom,k-1}\right) > \textbf{\textit{esr\_lambda\_thresh}} \rightarrow \lambda_{esr} = \lambda_{esr,a} \\ abs(\widehat{ESR}_{nom,k} - \widehat{ESR}^f_{nom,k-1}) < \textbf{\textit{esr\_lambda\_thresh}} \rightarrow \lambda_{esr} = \lambda_{esr,n} \end{cases} \qquad (11)$$

In some embodiments, the purpose of the low-pass filtering is to prevent errant measurements from quickly changing the nominal ESR value.

At step 414, the filtered, nominal ESR value is stored to memory. In some embodiments, the filtered, stored nominal ESR is utilized as the previous nominal ESR value in subsequent online learning modes. In addition, in some embodiments, the filtered nominal ESR value is provided as an output to the vehicle controller 110 upon request. As described above with respect to **FIG. 3,** the nominal ESR value calculated for each of the plurality of cells may be utilized to calculate SOH values associated with the plurality of cells (see steps 308 and 310) and may also be utilized to calculate operating ESR values during operation of the vehicle (see steps 314 and 316).

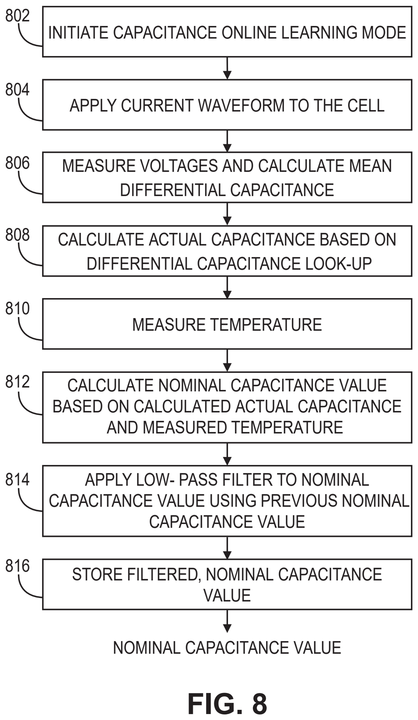

**FIG. 8** is a flowchart illustrating steps utilized to calculate nominal capacitance parameter according to some embodiments.

At step 802, the capacitance online learning mode is initiated. In some embodiments, the capacitance online learning mode and ESR online learning mode utilize the same current waveform and the learning modes are thus one and the same and conducted at the same time. In other embodiments, however, the ESR learning mode and the capacitance learning mode may be initiated independently of one another.

At step 804, a current waveform is applied to the UCM cell stack 116, which includes the plurality of ultra-capacitor cells C1-C5. An example of the current waveform is shown in **FIG. 5,** in which a plurality of pulses of a given magnitude are applied to the UCM cell stack 116. In the example shown in **FIG. 5,** the amplitude of the current pulse is labeled *I_pulse* and is approximately an order of magnitude greater than the rated current capacitance of the ultra-capacitor stack 116 (e.g., 30 amps).

At step 806, voltages are measured at selected points along the current waveform. In some embodiments, a differential capacitance of each cell is utilized to estimate the cell capacitance. The differential capacitance is provided by the following equation:

$$C_{d,i} = \frac{dq_i}{dV_i} = \frac{I_i \cdot \Delta t}{\Delta V_i} \qquad (12)$$

where $C_{d,i}$ is the differential capacitance, $I_i$ is the current provided at timestep $i$, $\Delta t$ is the time between voltage measurements, starting with $V_{cap-1}$ measured *Cap_start_t* seconds after the leading edge of the first pulse *I_pulse* and ending with a voltage a set amount greater than the starting voltage $V_{cap-1}$ (i.e., ending with a voltage rise *Cap_Learn_dv*), and $\Delta V_i$ is the change in voltage measured with respect to each $\Delta t$. In some embodiments, imposing a delay of *Cap_start_t* seconds after initiation of the first pulse minimizes the impact of polarization overpotential.

In some embodiments, the total rise in voltage between $V_{cap-1}$ and $V_{cap-2}$ is set to a fixed amount. For example, in the embodiment shown in **FIG. 5,** the ending voltage is labeled $V_{cap-2}$, wherein $V_{cap-2} = V_{cap-1} + Cap\_Learn\_dv$). That is, the value of *Cap_Learn_dv* determines the total rise in voltage from the first voltage value of $V_{cap-1}$. In this way, a plurality of differential capacitance measurements are recorded as the voltage rises from $V_{cap-1}$ to $V_{cap-2}$ (wherein $V_{cap-2}$ corresponds with a voltage rise of *Cap_Learn_dv*). Because differential capacitance is dependent on bias voltage, one of the benefits of fixing the end voltage at a value a set amount greater than the initial voltage ($V_{cap-2} = V_{cap-1} + Cap\_Learn\_dv$) is that variation effects of voltage dependency on the estimated capacitance are minimized.

In some embodiments, the differential capacitance calculated at step 806 is a mean, differential capacitance, wherein an average value of the plurality of differential capacitances is calculated as follows:

$$C_{d,m} = \frac{\Sigma_{V=V_{cap-1}}^{V=V_{cap-2}} C_{d,i}}{n} \tag{13}$$

where $n$ is the number of differential capacitances measured and the subscript $m$ in $C_{d,m}$ denotes that the differential capacitance is a mean value. In some embodiments, a mean, differential capacitance is calculated for each of the plurality of cells.

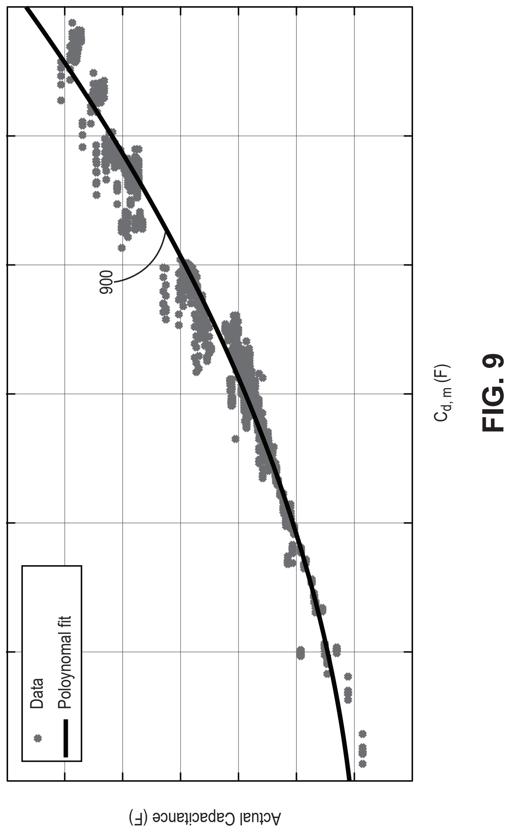

At step 808, the actual or one-time capacitance of each of the plurality of cells is calculated based on the mean, differential capacitance measured at step 806. For example, for a given capacitor, the relationship between differential capacitance and actual capacitance is illustrated via experimental data shown in FIG. 9. A best fit curve 900 is fixed to the data and utilized to convert the mean, differential capacitance measured at step 806 to an actual or one-time capacitance value. In some embodiments, the best fit curve 900 is described mathematically as a quadratic function:

$$C_{actual} = a_0 + a_1 \cdot C_{d,m} + a_2 \cdot C_{d,m}^2 \tag{14}$$

where $a_0$, $a_1$, and $a_2$ are the coefficients of a 2nd degree polynomial.

At step 810, the temperature of the UCM cell stack 116 is measured using temperature sensor 216. As discussed above, in some embodiments a plurality of temperature sensors may be utilized to measure temperature associated with each of the plurality of ultra-capacitor cells C1-C5.

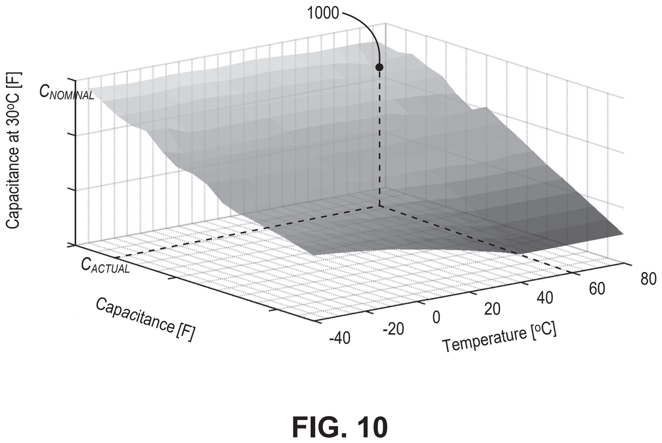

At step 812, a nominal capacitance value is calculated based on the actual or one-time capacitance $C_{actual}$ and the measured temperature. The nominal capacitance value is calculated to remove the temperature dependence from the measured actual capacitance. The measured capacitance - measured at a known temperature based on the temperature measured at step 810 - is converted to a nominal capacitance value that is associated with a set temperature (e.g., 30°C). Subsequent measured capacitance values - perhaps measured at a different temperature - are likewise converted to a nominal capacitance value associated with the same set temperature allowing the nominal capacitance value to be utilized to determine SOH of each of the plurality of cells. The conversion of the actual capacitance value $C_{actual}$ to a nominal capacitance $C_{nominal}$ value is based on the known relationship between capacitance and temperature. For example, the 3D graph shown in **FIG. 10** provides a visual representation of this relationship.

At step 814, a low pass filter is applied to the nominal capacitance value calculated at step 812 using a previously measured nominal capacitance value. For example, in some embodiments, the previously stored nominal capacitance value ( $\widehat{Cap}^f_{nom,k-1}$ ) is compared with the current nominal capacitance value ( $\widehat{Cap}^f_{nom,k}$ ) as follows:

$$\widehat{Cap}^f_{\text{nom},k} = \left(1 - \lambda_{cap}\right) \cdot \widehat{Cap}^f_{\text{nom},k-1} + \lambda_{cap} \cdot \widehat{Cap}_{\text{nom},k} \tag{15}$$

where the value of lambda is determined based on the following:

$$if \begin{cases} abs\left(\widehat{Cap}_{\text{nom},k} - \widehat{Cap}^f_{\text{nom},k-1}\right) > \boldsymbol{cap\_lambda\_thresh} \rightarrow \lambda_{cap} = \lambda_{cap,a} \\ abs(\widehat{Cap}_{\text{nom},k} - \widehat{Cap}^f_{\text{nom},k-1}) < \boldsymbol{cap\_lambda\_thresh} \rightarrow \lambda_{cap} = \lambda_{cap,n} \end{cases} \tag{16}$$

In some embodiments, the purpose of the low-pass filtering is to prevent errant measurements from quickly changing the nominal capacitance value.

At step 816, the filtered, nominal capacitance value is stored to memory. In some embodiments, the filtered, stored nominal capacitance is utilized as the previous nominal capacitance value in subsequent online learning modes. In addition, in some embodiments, the filtered nominal capacitance value is provided as an output to the vehicle controller 110 upon request. As described above with respect to **FIG. 3,** the nominal capacitance value calculated for each of the plurality of cells may be utilized to calculate SOH values associated with the plurality of cells (see steps 308 and 310) and may also be utilized to calculate operating capacitance values during operation of the vehicle (see steps 314 and 316).

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

Clause 1. A method of determining status of health (SOH) of an ultra-capacitor cell stack having a plurality of ultra-capacitor cells, the method comprising: measuring a parameter of each of the plurality of ultra-capacitor cells; measuring a temperature associated with each of the ultra-capacitor cells; converting the parameter measured with respect to each of the plurality of ultra-capacitor cells to a nominal parameter based on the measured temperature; calculating the SOH of the cell stack based on the nominal parameters associated with each of the plurality of ultra-capacitor cells.

Clause 2. The method of clause 1, wherein the parameter measured with respect to each of the ultra-capacitor cells is an equivalent series resistance (ESR), a capacitance, or both an ESR and a capacitance.

Clause 3. The method of clause 2, wherein calculating the SOH of the cell stack based on the nominal parameters associated with each of the plurality of ultra-capacitor cells includes: calculating a cell ESR-based SOH value for each of the plurality of ultra-capacitor cells based on the nominal ESR, a beginning of life (BOL) ESR value, and an end-of-life (EOL) ESR value; and selecting a minimum cell ESR-based SOH value as representative of the SOH of the cell stack.

Clause 4. The method of clauses 2 or 3, wherein calculating the SOH of the cell stack based on the nominal parameters associated with each of the plurality of ultra-capacitor cells includes: calculating a cell capacitance-based SOH value for each of the plurality of ultra-capacitor cells based on the nominal capacitance, a beginning of life (BOL) capacitance value, and an end-of-life (EOL) capacitance value; and selecting a minimum cell capacitance-based SOH value as representative of the SOH of the cell stack

Clause 5. The method of clauses 2, 3, or 4, wherein calculating the SOH of the cell stack based on the nominal parameters associated with each of the plurality of ultra-capacitor cells includes: calculating an ESR-based SOH value based on a plurality of cell ESR-based SOH values calculated based on the nominal ESR values associated with each of the plurality of ultra-capacitor cells; calculating a capacitance-based SOH value based on a plurality of cell capacitance-based SOH values calculated based on the nominal capacitance values associated with each of the plurality of ultra-capacitor cells; and calculating the SOH of the cell stack based on the ESR-based SOH value and the capacitance-based SOH value.

Clause 6. The method of clause 5, wherein calculating the SOH of the cell stack based on the ESR-based SOH and the capacitance-based SOH value includes selecting a minimum value as representative of the SOH of the UCM cell stack.

Clause 7. The method of clauses 1-6, wherein converting the measured parameter to a nominal parameter based on the measured temperature includes using at least one of a stored equation or a look-up table to convert the measured parameter to the nominal parameter based on the measured temperature.

Clause 8. The method of clauses 1-7, further including: applying a low-pass filter to the nominal parameter based on a previously measured nominal parameter.

Clause 9. The method of clauses 1-8, further including: receiving a request from a vehicle controller to provide an operating parameter of the ultra-capacitor cell; measuring an operating temperature of the ultra-capacitor cell; and calculating the operating parameter based on the measured operating temperature and the nominal parameter.

Clause 10. The method of clauses 2-9, wherein measuring the capacitance further includes: applying a current waveform to the ultra-capacitor cell; measuring a plurality of voltages at selected points in time with respect to the current waveform; calculating a differential capacitance of the ultra-capacitor cell based on the measured voltages; averaging the calculated differential capacitances to generate a mean, differential capacitance; and calculating an actual capacitance of the ultra-capacitor cell based on a known relationship between the actual capacitance and the mean, differential capacitance, wherein the actual capacitance is utilized as the measured parameter.

Clause 11. The method of clause 10, wherein the current waveform has an ampere magnitude approximately an order of magnitude higher than a rated current for measuring the capacitance of the ultra-capacitor cell.

Clause 12. A method of measuring capacitance of ultra-capacitor cells, the method comprising: applying a current waveform to the ultra-capacitor cell; measuring voltages at a plurality of time steps associated with the current waveform; calculating a differential capacitance based on the measured voltages; and calculating an actual capacitance based on a known relationship between the differential capacitance and the actual capacitance.

Clause 13. The method of clause 12, wherein a first voltage measured is measured a given time period after a leading edge of a first pulse of the current waveform.

Clause 14. The method of clause 13, wherein a last voltage measured at a last time step has a voltage magnitude a fixed amount greater than the first voltage.

Clause 15. The method of clauses 12-14, wherein the current waveform has an ampere magnitude approximately an order of magnitude higher than a rated current for measuring the rated capacitance of the ultra-capacitor cell.

Clause 16. The method of clauses 12-15, further including: measuring a temperature associated with the ultra-capacitor cell; converting the measured capacitance to a nominal capacitance based on the measured temperature; and calculating the state of health (SOH) of the ultra-capacitor cell based on the nominal capacitance.

Clause 17. An ultra-capacitor control module (UCM) comprising: a DC-to-DC converter; a plurality of ultra-capacitor cells connected to receive power from and source power to the DC-to-DC converter; and a UCM controller configured to monitor a current generated by the DC-to-DC converter and a voltage associated with each of the plurality of ultra-capacitor cells, the UCM controller including a computer readable medium configured to store instructions executed by a processor to: calculate a parameter of each of the plurality of ultra-capacitor cells based on voltages measured in response to an applied current profile; convert the measured parameters associated with each of the plurality of ultra-capacitor cells to nominal parameters based on a temperature measured with respect to the plurality of ultra-capacitor cells; calculate a cell state of health (SOH) value for each of the plurality of ultra-capacitor cells based on the nominal parameter associated with each of the plurality of ultra-capacitor cells; and calculate a cell stack SOH value based on the cell SOH values associated with each of the plurality of ultra-capacitor cells.

Clause 18. The UCM module of clause 17, wherein the parameter of the ultra-capacitor cell is equivalent series resistance (ESR).

Clause 19. The UCM module of clauses 17 or 18, wherein the parameter of the ultra-capacitor cell is capacitance.

Clause 20. The UCM module of clauses 17-19, wherein converting the measured parameter to a nominal parameter utilizes a stored equation or a look-up table to convert the measured parameter to the nominal parameter based on the measured temperature.

## Claims

1. A method of determining status of health (SOH) of an ultra-capacitor cell stack having a plurality of ultra-capacitor cells, the method comprising:

   measuring a parameter of each of the plurality of ultra-capacitor cells (step 304);
   measuring a temperature associated with each of the ultra-capacitor cells (step 304);
   converting the parameter measured with respect to each of the plurality of ultra-capacitor cells to a nominal parameter based on the measured temperature (step 306);
   calculating the SOH of the cell stack based on the nominal parameters associated with each of the plurality of ultra-capacitor cells (step 308).

2. The method of claim 1, wherein the parameter measured with respect to each of the ultra-capacitor cells is an equivalent series resistance (ESR), a capacitance, or both an ESR and a capacitance.

3. The method of any preceding claim, wherein calculating the SOH of the cell stack based on the nominal parameters associated with each of the plurality of ultra-capacitor cells includes:

   calculating a cell ESR-based SOH value for each of the plurality of ultra-capacitor cells based on the nominal ESR, a beginning of life (BOL) ESR value, and an end-of-life (EOL) ESR value; and
   selecting a minimum cell ESR-based SOH value as representative of the SOH of the cell stack.

4. The method of any preceding claim, wherein calculating the SOH of the cell stack based on the nominal parameters associated with each of the plurality of ultra-capacitor cells includes:

   calculating a cell capacitance-based SOH value for each of the plurality of ultra-capacitor cells based on the nominal capacitance, a beginning of life (BOL) capacitance value, and an end-of-life (EOL) capacitance value (step 308); and
   selecting a minimum cell capacitance-based SOH value as representative of the SOH of the cell stack (step 310).

5. The method of any preceding claim, wherein calculating the SOH of the cell stack based on the nominal parameters associated with each of the plurality of ultra-capacitor cells includes:

   calculating an ESR-based SOH value based on a plurality of cell ESR-based SOH values calculated based on the nominal ESR values associated with each of the plurality of ultra-capacitor cells (step 308);

calculating a capacitance-based SOH value based on a plurality of cell capacitance-based SOH values calculated based on the nominal capacitance values associated with each of the plurality of ultra-capacitor cells (step 308); and

calculating the SOH of the cell stack based on the ESR-based SOH value and the capacitance-based SOH value (step 310).

6. The method of claim 5, wherein calculating the SOH of the cell stack based on the ESR-based SOH and the capacitance-based SOH value includes selecting a minimum value as representative of the SOH of the UCM cell stack (step 310).

7. The method of any preceding claim, wherein converting the measured parameter to a nominal parameter based on the measured temperature includes using at least one of a stored equation or a look-up table to convert the measured parameter to the nominal parameter based on the measured temperature.

8. The method of any preceding claim, further including:

receiving a request from a vehicle controller to provide an operating parameter of the ultra-capacitor cell (step 312);

measuring an operating temperature of the ultra-capacitor cell (step 314); and

calculating the operating parameter based on the measured operating temperature and the nominal parameter (step 316).

9. The method of claim 2, wherein measuring the capacitance further includes:

applying a current waveform to the ultra-capacitor cell (step 804);

measuring a plurality of voltages at selected points in time with respect to the current waveform (step 806);

calculating a differential capacitance of the ultra-capacitor cell based on the measured voltages (step 806);

averaging the calculated differential capacitances to generate a mean, differential capacitance (step 806); and

calculating an actual capacitance of the ultra-capacitor cell based on a known relationship between the actual capacitance and the mean, differential capacitance, wherein the actual capacitance is utilized as the measured parameter (step 808).

10. The method of claim 2, wherein measuring capacitance of ultra-capacitor cells comprises:

applying a current waveform to the ultra-capacitor cell (step 804);

measuring voltages at a plurality of time steps associated with the current waveform (step 806);

calculating a differential capacitance based on the measured voltages (step 806); and

calculating an actual capacitance based on a known relationship between the differential capacitance and the actual capacitance (step 808).

11. The method of claim 10, wherein a first voltage measured (VCap_1) is measured a given time period after a leading edge of a first pulse of the current waveform, wherein a last voltage measured (VCap_2) at a last time step has a voltage magnitude a fixed amount greater than the first voltage.

12. The method of claim 10 or 11, wherein the current waveform has an ampere magnitude approximately an order of magnitude higher than a rated current for measuring the rated capacitance of the ultra-capacitor cell.

13. An ultra-capacitor control module (UCM) (106) comprising:

a DC-to-DC converter (112. 112a. 112b);

a plurality of ultra-capacitor cells (116, C1, C2, C3, C4, C5) connected to receive power from and source power to the DC-to-DC converter (112. 112a. 112b); and

a UCM controller (114) configured to monitor a current generated by the DC-to-DC converter (112. 112a. 112b) and a voltage associated with each of the plurality of ultra-capacitor cells (116, C1, C2, C3, C4, C5), the UCM controller (114) including a computer readable medium configured to store instructions executed by a processor to:

calculate a parameter of each of the plurality of ultra-capacitor cells based on voltages measured in response to an applied current profile (step 304);

convert the measured parameters associated with each of the plurality of ultra-capacitor cells to nominal parameters based on a temperature measured with respect to the plurality of ultra-capacitor cells (step 306);

calculate a cell state of health (SOH) value for each of the plurality of ultra-capacitor cells based on the nominal parameter associated with each of the plurality of ultra-capacitor cells (step 308); and

calculate a cell stack SOH value based on the cell SOH values associated with each of the plurality of ultra-capacitor cells (step 308).

14. The UCM (106) module of claim 13, wherein the parameter of the ultra-capacitor cell is equivalent series resistance (ESR) or capacitance.

15. The UCM (106) module of claims 13 or 14, wherein converting the measured parameter to a nominal parameter utilizes a stored equation or a look-up table to convert the measured parameter to the nominal parameter based on the measured temperature.

FIG. 1

FIG. 2

EP 4 756 464 A1

FIG. 3

402 — INITIATE ESR ONLINE LEARNING MODE

404 — APPLY CURRENT WAVEFORM TO EACH OF THE PLURALITY OF CELLS

406 — MEASURE VOLTAGES AND CALCULATE ESR FOR EACH OF THE PLURALITY OF CELLS

408 — MEASURE TEMPERATURE

410 — CALCULATE TEMPERATURE NOMINAL ESR VALUE BASED ON CALCULATED ESR AND MEASURED TEMPERATURE FOR EACH OF THE PLURALITY OF CELLS

412 — APPLY LOW-PASS FILTER TO NOMINAL ESR VALUE USING PREVIOUS NOMINAL ESR VALUE

414 — STORE NOMINAL ESR VALUE TO MEMORY

NOMINAL ESR VALUE

# FIG. 4

FIG. 5

**FIG. 6**

**FIG. 7**

802 INITIATE CAPACITANCE ONLINE LEARNING MODE

↓

804 APPLY CURRENT WAVEFORM TO THE CELL

↓

806 MEASURE VOLTAGES AND CALCULATE MEAN DIFFERENTIAL CAPACITANCE

↓

808 CALCULATE ACTUAL CAPACITANCE BASED ON DIFFERENTIAL CAPACITANCE LOOK-UP

↓

810 MEASURE TEMPERATURE

↓

812 CALCULATE NOMINAL CAPACITANCE VALUE BASED ON CALCULATED ACTUAL CAPACITANCE AND MEASURED TEMPERATURE

↓

814 APPLY LOW- PASS FILTER TO NOMINAL CAPACITANCE VALUE USING PREVIOUS NOMINAL CAPACITANCE VALUE

↓

816 STORE FILTERED, NOMINAL CAPACITANCE VALUE

↓

NOMINAL CAPACITANCE VALUE

# FIG. 8

**FIG. 9**

EP 4 756 464 A1

**FIG. 10**

**FIG. 11**

Europäisches
Patentamt

European
Patent Office

Office européen
des brevets

## EUROPEAN SEARCH REPORT

**Application Number**

EP 25 22 0481

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/044996 A1 (WORRY MICHAEL [US] ET AL) 8 February 2024 (2024-02-08) | 1,2,7,8, 11,12, 14,15 | INV. G01R31/64 |
| A | * paragraph [0059]; figures 1A-1E,2A-2D,4 * | 3-6,9, 10,13 | ADD. G01R1/44 |
| X | BAEK DONG-CHEON ET AL: "Temperature aspect of degradation of electrochemical double-layer capacitors (EDLC)", INTERNATIONAL CONFERENCE ON EXPERIMENTAL MECHANICS 2014, 2014-11-15¦2014-11-17, SINGAPORE, SINGAPORE ; 2015-03-04 ; SPIE ; 1000 20TH ST. BELLINGHAM WA 98225-6705 USA, vol. 9302, 4 March 2015 (2015-03-04), pages 930217-930217, XP060045859, ISSN: 0277-786X, DOI: 10.1117/12.2080945 ISBN: 978-1-62841-388-5 | 1 | |
| A | * abstract * * Section 1. "INTRODUCTION" * | 2-15 | |
| X | KR 2022 0139719 A (VINATECH CO LTD [KR]) 17 October 2022 (2022-10-17) | 1 | TECHNICAL FIELDS SEARCHED (IPC) G01R |
| A | * paragraphs [0115], [0116]; claims 1,2,3; figures 1,3 * | 2-15 | |
| X | FR 2 797 345 A1 (UNIV CLAUDE BERNARD LYON [FR]) 9 February 2001 (2001-02-09) | 1 | |
| A | * claim 1 * | 2-15 | |
| X | US 2009/088993 A1 (PANASONIC CORP [JP]; MATSUSHITA ELECTRIC INDUSTRIAL CO LTD [JP]) 2 April 2009 (2009-04-02) | 1 | |
| A | * claim 1 * | 2-15 | |
| X | US 2014/114592 A1 (EILERTSEN THOR E [US]) 24 April 2014 (2014-04-24) | 1 | |
| A | * claims 1,9; figures 2,3 * | 2-15 | |

-/--

The present search report has been drawn up for all claims

| Place of search | Date of completion of the search | Examiner |
|---|---|---|
| Munich | 28 April 2026 | Dogueri, Ali Kerem |

EPO FORM 1503 03.82 (P04C01)

Europäisches
Patentamt

European
Patent Office

Office européen
des brevets

**EUROPEAN SEARCH REPORT**

Application Number

EP 25 22 0481

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/379057 A1 (EL HAYEK ANTOINE [FR] ET AL) 3 December 2020 (2020-12-03) | 1 | |
| A | * claims 1,2,3 * | 2-15 | |
| | ----- | | |
| X | US 2020/363480 A1 (SCHNELL MARCO [DE]) 19 November 2020 (2020-11-19) | 1 | |
| A | * paragraph [0075]; claim 1 * | 2-15 | |
| | ----- | | |
| X | US 2009/112493 A1 (ABDENNADHER KARIM [FR]; MGE UPS SYSTEMS [FR] ET AL.) 30 April 2009 (2009-04-30) | 1 | |
| A | * claim 1 * | 2-15 | |
| | ----- | | |
| X | CN 117 269 850 A (UNIV TONGJI) 22 December 2023 (2023-12-22) | 13 | |
| A | * paragraphs [0017], [0057]; figure 3 * | 1-12,14, 15 | |
| | ----- | | |
| A | SOLIMAN HAMMAM ET AL: "A Review of the Condition Monitoring of Capacitors in Power Electronic Converters", IEEE TRANSACTIONS ON INDUSTRY APPLICATIONS. IEEE SERVICE CENTER, PISCATAWAY, NJ., US, vol. 52, no. 6, 1 November 2016 (2016-11-01), pages 4976-4989, XP011634697, ISSN: 0093-9994, DOI: 10.1109/TIA.2016.2591906 [retrieved on 2016-11-18] * the whole document * | 1-15 | **TECHNICAL FIELDS SEARCHED (IPC)** |
| | ----- | | |

The present search report has been drawn up for all claims

| Place of search | Date of completion of the search | Examiner |
|---|---|---|
| Munich | 28 April 2026 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 4 756 464 A1

### ANNEX TO THE EUROPEAN SEARCH REPORT
### ON EUROPEAN PATENT APPLICATION NO.

EP 25 22 0481

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2026

| Patent document cited in search report | | Publication date | Patent family member(s) | | Publication date |
|---|---|---|---|---|---|
| US 2024044996 | A1 | 08-02-2024 | CA | 3248321 A1 | 03-08-2023 |
| | | | CN | 118633221 A | 10-09-2024 |
| | | | CN | 121584837 A | 27-02-2026 |
| | | | EP | 4469813 A2 | 04-12-2024 |
| | | | US | 2023236258 A1 | 27-07-2023 |
| | | | US | 2024044996 A1 | 08-02-2024 |
| | | | WO | 2023146900 A2 | 03-08-2023 |
| KR 20220139719 | A | 17-10-2022 | NONE | | |
| FR 2797345 | A1 | 09-02-2001 | AT | E241145 T1 | 15-06-2003 |
| | | | AU | 6848200 A | 05-03-2001 |
| | | | EP | 1198715 A1 | 24-04-2002 |
| | | | FR | 2797345 A1 | 09-02-2001 |
| | | | WO | 0111377 A1 | 15-02-2001 |
| US 2009088993 | A1 | 02-04-2009 | CN | 101189145 A | 28-05-2008 |
| | | | EP | 1870289 A1 | 26-12-2007 |
| | | | JP | 4797488 B2 | 19-10-2011 |
| | | | JP | 2007030650 A | 08-02-2007 |
| | | | US | 2009088993 A1 | 02-04-2009 |
| | | | WO | 2007013362 A1 | 01-02-2007 |
| US 2014114592 | A1 | 24-04-2014 | NONE | | |
| US 2020379057 | A1 | 03-12-2020 | CN | 112014659 A | 01-12-2020 |
| | | | EP | 3745145 A1 | 02-12-2020 |
| | | | US | 2020379057 A1 | 03-12-2020 |
| US 2020363480 | A1 | 19-11-2020 | CN | 111417861 A | 14-07-2020 |
| | | | DE | 102017221096 A1 | 29-05-2019 |
| | | | EP | 3555644 A1 | 23-10-2019 |
| | | | ES | 2949848 T3 | 03-10-2023 |
| | | | SI | 3555644 T1 | 29-09-2023 |
| | | | US | 2020363480 A1 | 19-11-2020 |
| | | | WO | 2019101273 A1 | 31-05-2019 |
| US 2009112493 | A1 | 30-04-2009 | CN | 101424716 A | 06-05-2009 |
| | | | EP | 2056116 A1 | 06-05-2009 |
| | | | ES | 2687079 T3 | 23-10-2018 |
| | | | FR | 2923020 A1 | 01-05-2009 |
| | | | US | 2009112493 A1 | 30-04-2009 |
| CN 117269850 | A | 22-12-2023 | NONE | | |

EPO FORM P0459

For more details about this annex : see Official Journal of the European Patent Office, No. 12/82